# EUROPEAN PATENT APPLICATION

(11) **EP 4 746 671 A1**
(43) Date of publication of application: **20.05.2026**
(21) Application number: 25209058.4
(22) Date of filing: 16.10.2025
(51) Int. Cl.: H10P 72/00

(54) **SUBSTRATE PROCESSING METHOD AND SUBSTRATE PROCESSING APPARATUS**

(30) Priority: 21.10.2024 JP 2024184982
(71) Applicant: SCREEN Holdings Co., Ltd., Kyoto-shi, Kyoto 602-8585 (JP)
(72) Inventor: YAMAGUCHI, Yu, Kyoto, 602-8585 (JP); INABA, Masaki, Kyoto, 602-8585 (JP); LIN, Tsung Ju, Kyoto, 602-8585 (JP); TAMURA, Keigo, Kyoto, 602-8585 (JP)
(74) Representative: Kilian Kilian & Partner mbB

(57) **Abstract**

A substrate processing method includes forming a sealed space housing a substrate held by a substrate holder between a shielding member and the substrate holder by sealing a gap between the shielding member and the substrate holder in a state in which a component liquid is present on an upper surface of the substrate, and increasing gas pressure in the sealed space to a value higher than gas pressure outside the sealed space by supplying a component gas that generates a processing liquid together with the component liquid to the sealed space in a state in which the component liquid is present on the upper surface of the substrate.

## Description

### BACKGROUND OF THE INVENTION

### 1. Field of the Invention

The present invention relates to a substrate processing method and a substrate processing apparatus that process substrates. The substrates include a semiconductor wafer, a substrate for a FPD (flat panel display) such as a liquid crystal display and an organic EL (electroluminescence) display, a substrate for an optical disc, a substrate for a magnetic disk, a substrate for a magneto-optical disc, a substrate for a photomask, a ceramic substrate, a substrate for a solar cell, and the like.

### 2. Description of Related Art

JP 2023-34828A discloses processing a substrate with a sulfuric acid aqueous solution in which ozone is dissolved. Paragraph 0141 of JP 2023-34828A describes that "the inside of a processing chamber 12 can be pressurized by supplying an ozone-containing gas into the processing chamber 12 (pressurization supplying step). Thereby, the pressure inside the processing chamber 12 becomes higher than the pressure outside the processing chamber 12."

However, JP 2023-34828A does not disclose that a space housing a substrate is sealed by sealing a gap between a substrate holder and a shielding member. If the space housing the substrate is not sealed, the gas pressure in this space cannot be increased to a higher value.

At least one preferred embodiment of the present invention provides a substrate processing method and a substrate processing apparatus that are capable of efficiently generating a processing liquid containing a component liquid and a component gas on an upper surface of a substrate.

### SUMMARY OF THE INVENTION

A preferred embodiment of the present invention provides a substrate processing method including: causing a substrate holder to horizontally hold a substrate; supplying a component liquid to an upper surface of the substrate held by the substrate holder; forming a sealed space housing the substrate held by the substrate holder between a shielding member and the substrate holder by sealing a gap between the shielding member and the substrate holder in a state in which the component liquid is present on the upper surface of the substrate; and increasing gas pressure in the sealed space to a value higher than gas pressure outside the sealed space by supplying a component gas, which generates a processing liquid together with the component liquid, to the sealed space in a state in which the component liquid is present on the upper surface of the substrate.

In the preferred embodiment, at least one of the following features may be added to the substrate processing method.

Increasing the gas pressure in the sealed space includes keeping the gas pressure in the sealed space at a value higher than the gas pressure outside the sealed space by continuously supplying the component gas to the sealed space while discharging gas from the sealed space in a state in which the component liquid is present on the upper surface of the substrate.

The substrate holder includes a spin chuck that rotates the substrate while horizontally holding the substrate by a plurality of chuck pins arranged around the substrate, and a hot plate that heats the substrate while horizontally holding the substrate; the substrate processing method further includes moving the substrate between the spin chuck and the hot plate by relatively moving the spin chuck and the hot plate; supplying the component liquid includes discharging the component liquid toward the upper surface of the substrate held by the spin chuck while causing the spin chuck to rotate the substrate; increasing the gas pressure in the sealed space includes causing the hot plate to heat the substrate while holding the substrate in a state in which the component liquid is present on the upper surface of the substrate and the gas pressure in the sealed space is higher than the gas pressure outside the sealed space.

Forming the sealed space includes forming the sealed space housing the substrate held by the hot plate between the shielding member and the hot plate by sealing the gap between the shielding member and the hot plate in a state in which the component liquid is present on the upper surface of the substrate.

Increasing the gas pressure in the sealed space includes: diffusing the component gas into an upper space that is a portion of a space inside a tubular portion of the shielding member surrounding the substrate held by the substrate holder in a state in which the sealed space has been formed, the portion being located between a rectifying plate of the shielding member located above the substrate held by the substrate holder and a plate-shaped portion of the shielding member located above the rectifying plate; and supplying the component gas existing in the upper space to a lower space that is a portion of the space inside the tubular portion of the shielding member and that is a space below the rectifying plate through a plurality of gas passages vertically penetrating the rectifying plate.

The substrate processing method further includes: reducing gas pressure in the sealed space by discharging the component gas from the sealed space; and supplying replacement gas, which is gas other than the component gas, to the sealed space after the gas pressure in the sealed space decreases in a state in which the sealed space is filled with the component gas and the component gas is discharged from the sealed space.

The substrate processing method further includes: pressurization preparation to discharge gas in the space between the shielding member and the substrate holder through the gap by supplying the component gas to the space between the shielding member and the substrate holder in a state in which the gap between the shielding member and the substrate holder is not sealed.

The pressurization preparation includes discharging gas in a guard through a discharged gas duct located below the gap between the shielding member and the substrate holder while positioning an upper end of the guard surrounding the shielding member and the substrate holder in a plan view above the gap when the component gas is supplied to the space between the shielding member and the substrate holder in a state in which the gap is not sealed.

The substrate processing method further includes supplying a liquid of an organic solvent having higher volatility than water to the upper surface of the substrate held by the substrate holder after supplying the component gas to the sealed space; and evaporating the liquid of the organic solvent on the upper surface of the substrate until the upper surface of the substrate is dried by discharging gas from the sealed space to reduce the gas pressure in the sealed space in a state in which the liquid of the organic solvent is present on the upper surface of the substrate.

Forming the sealed space is forming the sealed space housing the substrate held by the substrate holder between the shielding member and the substrate holder by sealing the gap between the shielding member and the substrate holder in a chamber housing the shielding member and the substrate holder in a state in which the component liquid is present on the upper surface of the substrate.

Another preferred embodiment of the present invention provides a substrate processing apparatus including: a substrate holder that horizontally holds a substrate; a component liquid nozzle that discharges a component liquid toward an upper surface of the substrate held by the substrate holder; a shielding member; a relative movement actuator that forms a sealed space housing the substrate held by the substrate holder between the shielding member and the substrate holder by reducing a distance between the shielding member and the substrate holder and by sealing a gap between the shielding member and the substrate holder in a state in which the component liquid is present on the upper surface of the substrate; and a component gas piping that increases gas pressure in the sealed space to a value higher than gas pressure outside the sealed space by supplying a component gas, which generates a processing liquid together with the component liquid, to the sealed space in a state in which the component liquid is present on the upper surface of the substrate.

In the preferred embodiment, at least one of the following features may be added to the substrate processing apparatus.

The substrate processing apparatus further includes a discharged gas pipe that sucks gas in a space between the shielding member and the substrate holder, and the component gas piping keeps the gas pressure in the sealed space at a value higher than the gas pressure outside the sealed space by continuously supplying the component gas to the sealed space when the discharged gas pipe is discharging gas from the sealed space in a state in which the component liquid is present on the upper surface of the substrate.

The substrate holder includes a spin chuck that rotates the substrate while horizontally holding the substrate by a plurality of chuck pins arranged around the substrate and a hot plate that heats the substrate while horizontally holding the substrate; the substrate processing apparatus further includes a delivery actuator that moves the substrate between the spin chuck and the hot plate by relatively moving the spin chuck and the hot plate; the component liquid nozzle discharges the component liquid toward the upper surface of the substrate held by the spin chuck when the spin chuck is rotating the substrate; the hot plate heats the substrate while holding the substrate in a state in which the component liquid is present on the upper surface of the substrate and the gas pressure in the sealed space is higher than the gas pressure outside the sealed space.

The relative movement actuator forms the sealed space housing the substrate held by the hot plate between the shielding member and the hot plate by sealing the gap between the shielding member and the hot plate in a state in which the component liquid is present on the upper surface of the substrate.

The shielding member includes: a tubular portion that surrounds the substrate held by the substrate holder in a state in which the sealed space is formed; a rectifying plate that is located above the substrate held by the substrate holder; a plate-shaped portion that is located above the rectifying plate; and a gas supply port that supplies the component gas existing in an upper space, which is a portion of a space inside the tubular portion and a space between the rectifying plate and the plate-shaped portion, to a lower space, which is a portion of the space inside the tubular portion and a space below the rectifying plate, through a plurality of gas passages vertically penetrating the rectifying plate by supplying the component gas to the upper space.

The substrate processing apparatus further includes: a discharged gas pipe that reduces gas pressure in the sealed space by discharging the component gas from the sealed space; and a replacement gas piping that supplies replacement gas, which is gas other than the component gas, to the sealed space after the gas pressure in the sealed space has decreased in a state in which the sealed space is filled with the component gas and the discharged gas pipe is discharging the component gas from the sealed space.

The substrate processing apparatus further includes a component gas valve that is switched between an open state in which the component gas flowing in the component gas piping is allowed to pass through the component gas valve and a closed state in which the component gas valve stops the component gas flowing in the component gas piping; and a controller that causes the relative movement actuator to seal the gap between the shielding member and the substrate holder after gas in the space between the shielding member and the substrate holder is discharged through the gap by switching the component gas valve to the open state and by supplying the component gas to the space between the shielding member and the substrate holder in a state in which the gap between the shielding member and the substrate holder is not sealed.

The substrate processing apparatus further includes: a guard that includes an upper end surrounding the shielding member and the substrate holder in a plan view; a guard raising/lowering actuator that causes the upper end of the guard to be positioned above the gap between the shielding member and the substrate holder when the component gas is supplied to the space between the shielding member and the substrate holder in a state in which the gap between the shielding member and the substrate holder is not sealed; and a discharged gas duct that is located below the gap and that discharges gas existing in the guard.

The substrate processing apparatus further includes: an organic solvent nozzle that discharges a liquid of an organic solvent having higher volatility than water toward the upper surface of the substrate held by the substrate holder after supplying the component gas to the sealed space; and a discharged gas pipe that evaporates the liquid of the organic solvent on the upper surface of the substrate until the upper surface of the substrate is dried by discharging gas from the sealed space to reduce the gas pressure in the sealed space in a state in which the liquid of the organic solvent is present on the upper surface of the substrate.

The substrate processing apparatus further includes a chamber that houses the shielding member and the substrate holder.

### BRIEF DESCRIPTION OF THE DRAWINGS

FIG. 1A is a schematic plan view showing a layout of a substrate processing apparatus according to a preferred embodiment.
FIG. 1B is a schematic side view of the substrate processing apparatus.
FIG. 2 is a schematic view of an interior of a processing unit when viewed horizontally.
FIG. 3 is a schematic view of the interior of the processing unit when viewed horizontally.
FIG. 4 is an enlarged view of both a shielding member and a hot plate showing a state in which a gap between the shielding member and the hot plate is sealed.
FIGS 5A, 5B, and 5C are schematic views of a chuck pin.
FIG. 6 is a process chart for describing an example of processing of a substrate performed by the substrate processing apparatus.
FIG. 7 is a timing chart for describing a flow from when a space housing a substrate is sealed to when an ozone gas in the space is replaced with a nitrogen gas in the example of the processing of the substrate shown in FIG. 6.
FIG. 8 is a schematic view of a shielding member and a hot plate according to another preferred embodiment.
FIG. 9 is a schematic view of a shielding member and a hot plate according to still another preferred embodiment.

### DETAILED DESCRIPTION OF PREFERRED EMBODIMENTS

Preferred embodiments of the present invention will be explained in detail with reference to the accompanying drawings.

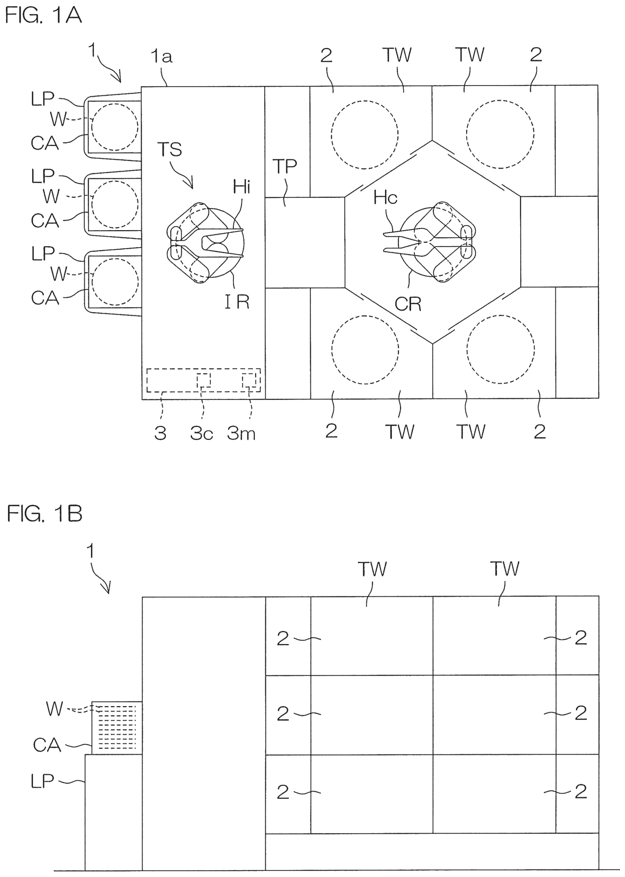

FIG. 1A is a schematic plan view showing a layout of a substrate processing apparatus 1 according to a preferred embodiment. FIG. 1B is a schematic side view of the substrate processing apparatus 1.

As shown in FIG. 1A, the substrate processing apparatus 1 is a single substrate processing type apparatus that processes disc-shaped substrates W such as semiconductor wafers one by one. The substrate processing apparatus 1 includes a load port LP that holds a carrier CA housing a plurality of substrates W, such as a FOUP (Front-Opening Unified Pod), a plurality of processing units 2 that process the substrates W transferred from the carrier CA on the load port LP with a processing fluid such as a processing liquid or processing gas, a transfer system TS that transfers the substrates W between the carrier CA on the load port LP and the plurality of processing units 2, an outer wall 1a that forms a sealed space housing the plurality of processing units 2 and the transfer system TS, and a controller 3 that controls the substrate processing apparatus 1.

The plurality of processing units 2 form a plurality of towers TW. FIG. 1A shows an example where four towers TW are formed. As shown in FIG. 1B, a plurality of processing units 2 included in a single tower TW are stacked vertically. As shown in FIG. 1A, the plurality of towers TW form two rows extending in the depth direction (the left-right direction of the paper in FIG. 1A) of the substrate processing apparatus 1 in a plan view. The two rows face each other across a transfer path TP in a plan view.

The transfer system TS includes an indexer robot IR that carries the substrates W into and out from the carrier CA on the load port LP and a center robot CR that carries the substrates W into and out from the processing units 2. The center robot CR is disposed in the transfer path TP. The indexer robot IR is disposed between the load port LP and the center robot CR in a plan view. The indexer robot IR transfers the substrate W to the center robot CR and receives the substrate W from the center robot CR. The same applies to the center robot CR.

The indexer robot IR includes one or more hands Hi that support the substrates W horizontally. The hand Hi is movable in parallel in both the horizontal direction and the vertical direction. The hand Hi is rotatable around a vertical line. The hand Hi can carry in and carry out the substrate W to and from the carrier CA on any of the load ports LP, and can receive and transfer the substrate W from and to the center robot CR.

The center robot CR includes one or more hands Hc that support the substrates W horizontally. The hand Hc is movable in parallel in both the horizontal direction and the vertical direction. The hand Hc is rotatable around a vertical line. The hand Hc can receive and transfer the substrate W from and to the indexer robot IR, and carry in and carry out the substrate W to and from any of the processing units 2.

The controller 3 controls electrical devices and electronic devices provided in the substrate processing apparatus 1. The controller 3 includes at least one computer capable of communicating with each other. The computer includes a CPU (Central Processing Unit) 3c that performs processing of information such as execution of a program and a memory 3m that stores information such as a program to be executed by the CPU 3c. A CPU is also called a processor. The controller 3 controls the substrate processing apparatus 1 to carry out transfer and processing of the substrate W described below. In other words, the controller 3 is programmed to carry out transfer and processing of the substrate W described below.

Next, the processing unit 2 will be described.

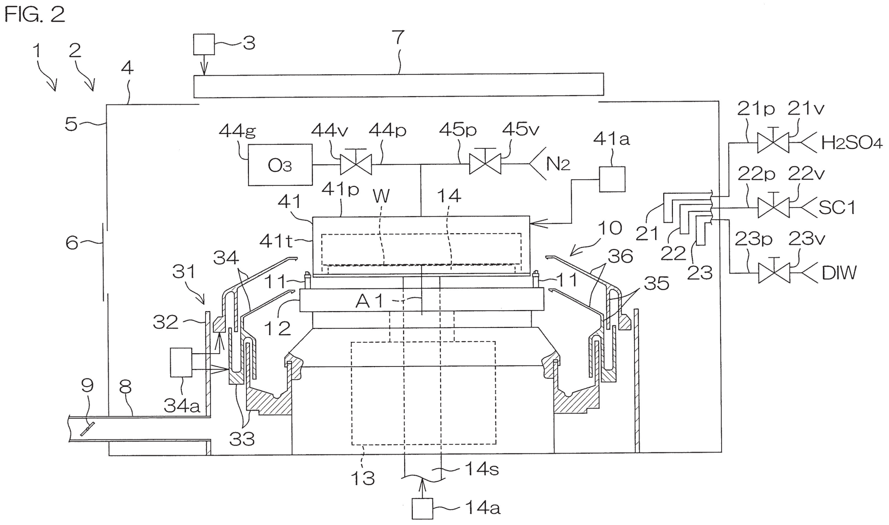

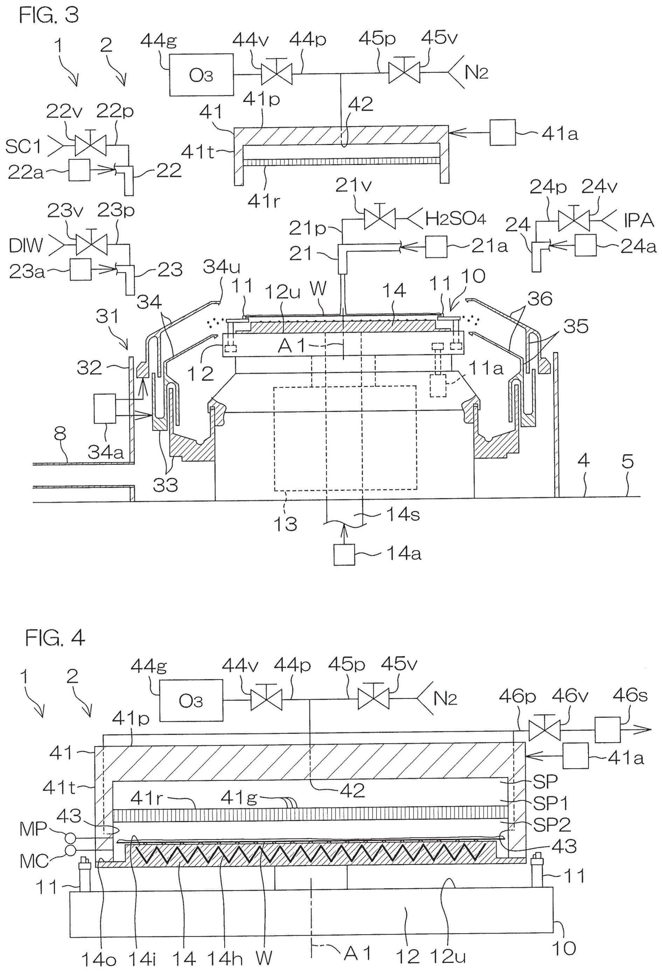

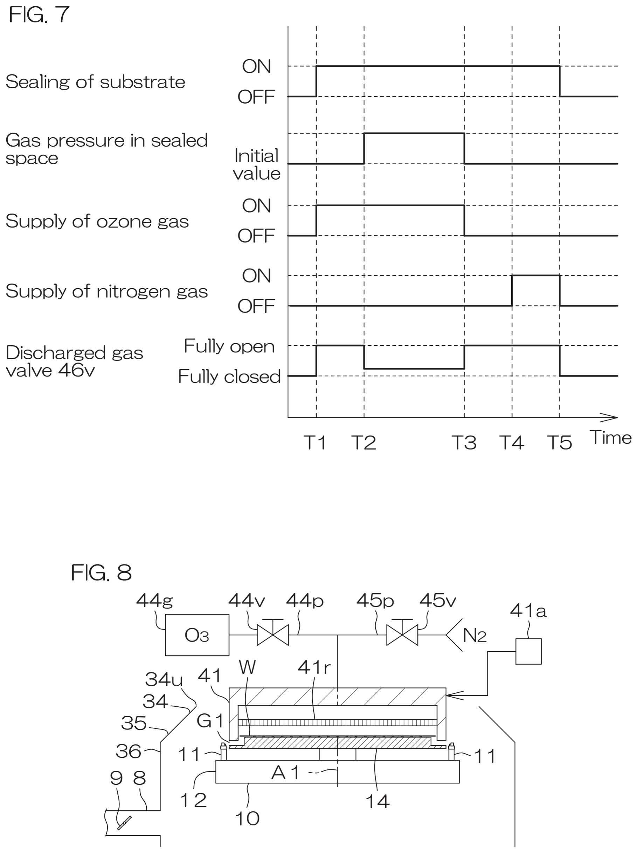

FIG. 2 and FIG. 3 are schematic views of an interior of the processing unit 2 when viewed horizontally. FIG. 2 shows a state in which a gap G1 (see FIG. 8) between a shielding member 41 and a hot plate 14 is sealed. FIG. 3 shows a state in which the gap between the shielding member 41 and the hot plate 14 is not sealed. FIG. 4 is an enlarged view of both the shielding member 41 and the hot plate 14 showing a state in which the gap between the shielding member 41 and the hot plate 14 is sealed.

As shown in FIG. 2, the processing unit 2 includes a chamber 4 that houses the substrate W, a spin chuck 10 that rotates one substrate W around a vertical rotational axis A1 passing through the central portion of the substrate W while holding the substrate W horizontally in the chamber 4.

The chamber 4 includes a box-shaped partition 5 provided with a passing port through which the substrate W passes, and a door 6 that opens and closes the passing port. An FFU 7 (Fan Filter Unit 7) is disposed over an air outlet provided on the upper portion of the partition 5. The FFU 7 constantly supplies clean air (air that has been filtered by a filter) from the air outlet to the chamber 4. The gas in the chamber 4 is discharged from the chamber 4 through a discharged gas duct 8 connected to the bottom portion of a processing cup 31. Thereby, a downflow of clean air is constantly formed inside the chamber 4. The flow rate of discharged gas to be discharged into the discharged gas duct 8 is changed according to the opening degree of a discharged gas valve 9 disposed in the discharged gas duct 8.

The spin chuck 10 includes a disc-shaped spin base 12 horizontally held, a plurality of chuck pins 11 that hold the substrate W horizontally above the spin base 12, and a spin motor 13 that rotates the spin base 12 and the plurality of chuck pins 11 around the rotational axis A1. Although the spin chuck 10 includes three or more chuck pins 11, FIG. 2 depicts the number of the chuck pins 11 is two. The same applies to FIG. 3 and the like.

The spin chuck 10 is not limited to a clamping type chuck that brings the plurality of chuck pins 11 into contact with the end surface of the substrate W, and may be a vacuum chuck that holds the substrate W horizontally by adsorbing the rear surface (lower surface) of the substrate W, which is a non-device forming surface, onto the upper surface 12u (refer to FIG. 3) of the spin base 12. When the spin chuck 10 is the clamping type chuck, the plurality of chuck pins 11 correspond to a substrate holder.

The processing unit 2 includes the tubular processing cup 31 that receives the processing liquid scattered from the substrate W. The processing cup 31 includes a plurality of guards 34 that receive the processing liquid discharged outward from the substrate W held by the spin chuck 10, a plurality of cups 33 that receive the processing liquid guided downward by the plurality of guards 34, and a tubular outer wall 32 surrounding the plurality of guards 34 and the plurality of cups 33. FIG. 2 shows an example where two guards 34 and two cups 33 are provided and the outer cup 33 is integral to the inner guard 34.

The guard 34 includes a cylindrical portion 35 surrounding the spin chuck 10 and an annular ceiling portion 36 extending upward obliquely from the upper end portion of the cylindrical portion 35 toward the rotational axis A1. The plurality of ceiling portions 36 overlap each other vertically, and the plurality of cylindrical portions 35 are concentrically disposed. The annular upper end of the ceiling portion 36 corresponds to the upper end 34u (refer to FIG. 3) of the guard 34 surrounding the substrate W and the spin base 12 in a plan view. The plurality of cup 33 are disposed under the plurality of cylindrical portions 35, respectively. The cup 33 forms an annular groove that receives the processing liquid guided downward by the guard 34.

The processing unit 2 includes a guard raising/lowering actuator 34a that individually raises and lowers the plurality of guards 34. The guard raising/lowering actuator 34a holds the guard 34 stationary at any position within a range from an upper position to a lower position. FIG. 2 shows a state where the outer guard 34 is disposed at the upper position and the inner guard 34 is disposed at the lower position. The upper position is a position where the upper end 34u of the guard 34 is disposed above a holding position where the substrate W held by the spin chuck 10 is positioned. The lower position is a position where the upper end 34u of the guard 34 is disposed below the holding position.

The actuator is a device that converts driving energy, which represents electrical, fluid, magnetic, thermal or chemical energy, to mechanical work, that is, motion of a tangible object. The actuator includes an electric motor (rotary motor), linear motor, air cylinder and other devices. If the motion of the actuator is different from the motion of the object, a motion converter may be provided to convert the motion of the actuator into linear motion or rotation. If the actuator is an electric motor and the object is to be moved in a linear motion, a motion converter, such as a ball screw and ball nut, may convert the rotation of the electric motor into linear motion.

The processing unit 2 includes a plurality of nozzles that discharge a processing fluid such as a processing liquid or processing gas toward the substrate W located above the spin chuck 10. The plurality of nozzles include a first chemical liquid nozzle 21 that discharges a first chemical liquid toward the upper surface of the substrate W located above the spin chuck 10, a second chemical liquid nozzle 22 that discharges a second chemical liquid toward the upper surface of the substrate W located above the spin chuck 10 and a rinse liquid nozzle 23 that discharges a rinse liquid toward the upper surface of the substrate W located above the spin chuck 10. FIG. 2 shows an example where the first chemical liquid is sulfuric acid (H₂SO₄), the second chemical liquid is SC1 and the rinse liquid is pure water (DIW).

The first chemical liquid nozzle 21 is connected to first chemical liquid piping 21p that guides the first chemical liquid. When a first chemical liquid valve 21v attached to the first chemical liquid piping 21p is opened, the discharge port of the first chemical liquid nozzle 21 continuously discharges the first chemical liquid downward. Similarly, the second chemical liquid nozzle 22 is connected to second chemical liquid piping 22p that guides the second chemical liquid. When a second chemical liquid valve 22v attached to the second chemical liquid piping 22p is opened, the discharge port of the second chemical liquid nozzle 22 continuously discharges the second chemical liquid downward. The first chemical liquid nozzle 21 is an example of a component liquid nozzle and the first chemical liquid valve 21v is an example of a component liquid valve. The first chemical liquid is an example of a component liquid.

The first chemical liquid may be a liquid that contains at least one of sulfuric acid, nitric acid, hydrochloric acid, hydrofluoric acid, phosphoric acid, acetic acid, ammonia water, a hydrogen peroxide solution, organic acid (e.g., such as citric acid or oxalic acid), organic alkaline (e.g., TMAH: tetramethyl ammonium hydroxide), a surface-active agent, and a corrosion inhibitor, or may be a liquid other than those. The same applies to the second chemical liquid. The first chemical liquid may be a chemical liquid that has the same composition as the second chemical liquid and differs from the second chemical liquid in at least one of concentration and temperature.

Although not shown, the first chemical liquid valve 21v includes a valve body provided with an annular valve seat through which the chemical liquid passes, a valve element that can move with respect to the valve seat, and an actuator that moves the valve element between a closed position where the valve element contacts the valve seat and an open position where the valve element is away from the valve seat. The same applies to other valves. The actuator may be a pneumatic actuator or an electric actuator, or may be an actuator other than these. The controller 3 opens and closes the first chemical liquid valve 21v and the like by controlling the actuator.

The rinse liquid nozzle 23 is connected to rinse liquid piping 23p that guides the rinse liquid. When a rinse liquid valve 23v attached to the rinse liquid piping 23p is opened, the discharge port of the rinse liquid nozzle 23 continuously discharges the rinse liquid downward. The rinse liquid may be any of pure water (DIW (Deionized Water)), carbonated water, electrolyzed ionized water, hydrogen water, ozone water, hydrochloric acid water having a dilution concentration (for example, about 1 to 100 ppm) and ammonia water having a dilution concentration (for example, about 1 to 100 ppm), or may be a liquid other than these.

The first chemical liquid nozzle 21 may be a scan nozzle that moves a collision position of the chemical liquid with respect to the substrate W within the upper surface of the substrate W, or may be a fixed nozzle that cannot move the collision position of the chemical liquid with respect to the substrate W. The same applies to the other nozzles. FIG. 3 shows an example in which the first chemical liquid nozzle 21, the second chemical liquid nozzle 22, and the rinse liquid nozzle 23 are scan nozzles, respectively.

As shown in FIG. 3, the first chemical liquid nozzle 21 is connected to a first nozzle actuator 21a that moves the first chemical liquid nozzle 21 in at least either one of the vertical direction and the horizontal direction. The second chemical liquid nozzle 22 is connected to a second nozzle actuator 22a that moves the second chemical liquid nozzle 22 in at least either one of the vertical direction and the horizontal direction. The rinse liquid nozzle 23 is connected to a third nozzle actuator 23a that moves the rinse liquid nozzle 23 in at least either one of the vertical direction and the horizontal direction.

The first nozzle actuator 21a horizontally moves the first chemical liquid nozzle 21 between a processing position at which a chemical liquid discharged from the first chemical liquid nozzle 21 is supplied to the upper surface of the substrate W and a standby position at which the first chemical liquid nozzle 21 is placed around the processing cup 31 in a plan view. The same applies to the second nozzle actuator 22a and the third nozzle actuator 23a. FIG. 3 shows a state in which the first chemical liquid nozzle 21 is located at the processing position.

As shown in FIG. 4, the processing unit 2 includes a hot plate 14 that is an example of a heater that heats the substrate W located above the spin chuck 10. The hot plate 14 is located between the substrate W and the spin base 12. The hot plate 14 includes a heating element 14h that generates Joule heat by energization, and an outer case that houses the heating element 14h. The heating element 14h and the outer case are located below the substrate W. The heating element 14h is connected to an electric wiring (not shown) that supplies power to the heating element 14h. The temperature of the heating element 14h is changed by the controller 3. When the controller 3 causes the heating element 14h to generate heat, the entirety of the substrate W is uniformly heated.

The outer case of the hot plate 14 includes a disc-shaped base portion located below the substrate W, and a plurality of hemispherical protrusion portions that protrude upwardly from an upper surface of the base portion. The upper surface of the base portion is parallel to a lower surface of the substrate W, and has an outer diameter smaller than the diameter of the substrate W. The plurality of protrusion portions are in contact with the lower surface of the substrate W at a position separated upwardly from the upper surface of the base portion. The plurality of protrusion portions are located at a plurality of positions, respectively, in the upper surface of the base portion so that the substrate W is horizontally supported. The substrate W is horizontally supported in a state in which the lower surface of the substrate W is separated upwardly from the upper surface of the base portion.

As shown in FIG. 3, the hot plate 14 is horizontally supported by a support shaft 14s extending downwardly from a central portion of the hot plate 14. The plurality of chuck pins 11 are arranged around the hot plate 14. A centerline of the hot plate 14 is located on the rotational axis A1 of the substrate W. Even when the spin chuck 10 rotates, the hot plate 14 does not rotate.

The hot plate 14 is vertically translatable with respect to the spin base 12. The hot plate 14 is connected to a raising/lowering actuator 14a through the support shaft 14s. The raising/lowering actuator 14a is an example of a delivery actuator. The raising/lowering actuator 14a vertically raises and lowers the hot plate 14 between the upper position (position shown in FIG. 4) and the lower position (position shown in FIG. 3). The upper position is a contact position at which the hot plate 14 comes into contact with the lower surface of the substrate W. The lower position is a proximal position located between the lower surface of the substrate W and the upper surface 12u of the spin base 12 in a state in which the hot plate 14 is separated from the substrate W.

The hot plate 14 is an example of the substrate holder. The raising/lowering actuator 14a stops the hot plate 14 at an arbitrary position within a range from the upper position to the lower position. When the hot plate 14 is raised to the upper position in a state in which the substrate W is supported by the plurality of chuck pins 11 and in which the holding of the substrate W is released, the substrate W is raised by the hot plate 14 and is separated upwardly from the plurality of chuck pins 11. When the hot plate 14 is lowered to the lower position in this state, the substrate W present on the hot plate 14 is placed on the plurality of chuck pins 11, and the hot plate 14 is separated downwardly from the substrate W.

The processing unit 2 includes the shielding member 41 located above the spin chuck 10. The shielding member 41 is located in the chamber 4. The shielding member 41 includes a plate-shaped portion 41p horizontally held and a tubular portion 41t extending downwardly from an outer peripheral portion of the plate-shaped portion 41p. The plate-shaped portion 41p is also referred to as a blocking plate. A lower surface of the plate-shaped portion 41p corresponds to a lower surface of the shielding member 41. The center of the plate-shaped portion 41p is located on the rotational axis A1 of the substrate W. The inner diameter of the tubular portion 41 t is smaller than the outer diameter of the spin base 12. The outer diameter of the tubular portion 41t is smaller than the inner diameter of the upper end 34u of the guard 34.

The shielding member 41 is connected to a raising/lowering actuator 41a that parallelly moves the shielding member 41 upwardly and downwardly. The raising/lowering actuator 41a is an example of a relative movement actuator. The raising/lowering actuator 41a stops the shielding member 41at an arbitrary position within a range from the upper position (position shown in FIG. 3) to the lower position (position shown in FIG. 4). The upper position is a standby position at which the shielding member 41 recedes to a height at which the scan nozzle can enter between the shielding member 41 and the substrate W when the substrate W is held by the plurality of chuck pins 11. The lower position is a sealed position at which a gap between the lower surface of the tubular portion 41t of the shielding member 41 and the upper surface of the hot plate 14 is sealed when the hot plate 14 is located at the upper position.

As shown in FIG. 4, the upper surface of the hot plate 14 includes a circular inner portion 14i vertically facing the substrate W and an annular outer portion 14o surrounding the inner portion 14i. The substrate W is placed on the inner portion 14i such that the center of the substrate W coincides with the center of the inner portion 14i. The diameter of the inner portion 14i is larger than the radius of the substrate W and is smaller than the diameter of the substrate W. The outer portion 14o is located below the inner portion 14i. The inner periphery and the outer periphery of the outer portion 14o have circular shapes concentric with the inner portion 14i. The width of the outer portion 14o (interval between the inner periphery and the outer periphery of the outer portion 14o) is smaller than the radius of the inner portion 14i.

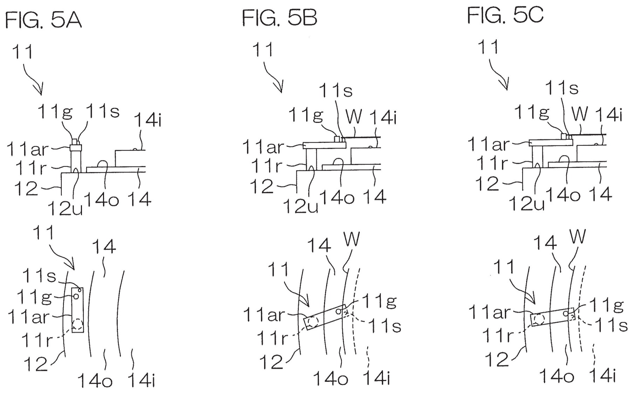

When the chuck pin 11 is located at a support position (position shown in FIG. 5B), the outer portion 14o of the hot plate 14 overlaps the chuck pin 11 in a plan view (when seen vertically in the downward direction). When the chuck pin 11 is located at a standby position (position shown in FIG. 5A), the outer portion 14o does not overlap the chuck pin 11 in a plan view. A gap between the lower surface of the tubular portion 41t of the shielding member 41 and the outer portion 14o of the hot plate 14 is sealed when the shielding member 41 is located at the lower position in a state in which the chuck pin 11 is located at the standby position and in which the hot plate 14 is located at the upper position. Thereby, a sealed space SP (see FIG. 4) housing the substrate W is formed between the shielding member 41 and the hot plate 14.

When the sealed space SP is formed between the shielding member 41 and the hot plate 14, the lower surface of the tubular portion 41t of the shielding member 41 may be directly pressed against the outer portion 14o of the hot plate 14, or may be pressed against the outer portion 14o through a rubber-made or resin-made seal ring. The seal ring may be held by either the shielding member 41 or the hot plate 14. When two seal rings are concentrically located between the shielding member 41 and the hot plate 14, a discharged gas path that discharges gas from an annular space formed by the two seal rings, the shielding member 41, and the hot plate 14 may be provided in either one of the shielding member 41 and the hot plate 14.

As shown in FIG. 4, the shielding member 41 includes a gas supply port 42 that supplies gas to a space inside the shielding member 41 (space inside the tubular portion 41t) and a gas discharge port 43 that discharges gas from the space. FIG. 4 shows an example in which the gas supply port 42 is opened at a central portion of the lower surface of the plate-shaped portion 41p and in which the gas discharge port 43 is opened at an inner peripheral surface of the tubular portion 41t. In this example, the gas discharge port 43 is located below the gas supply port 42.

The number of the gas supply ports 42 provided in the single shielding member 41 may be one or two or more. The same applies to the number of the gas discharge ports 43. The plurality of gas supply ports 42 may be located in at least one of the lower surface of the plate-shaped portion 41p and the inner peripheral surface of the tubular portion 41t along one or more circles concentric with the shielding member 41. Likewise, the plurality of gas discharge ports 43 may be located in at least one of the lower surface of the plate-shaped portion 41p and the inner peripheral surface of the tubular portion 41t along one or more circles concentric with the shielding member 41.

The shielding member 41 may or may not include a rectifying plate 41r that partitions the space inside the shielding member 41 in addition to the plate-shaped portion 41p and the tubular portion 41t. FIGS. 2 to 4 show examples of the former. The rectifying plate 41r is a horizontal disk concentric with the tubular portion 41t. The outer diameter of the rectifying plate 41r is equal to or substantially equal to the inner diameter of the tubular portion 41t. The rectifying plate 41r may be connected to either the plate-shaped portion 41p or the tubular portion 41t, or may be integrated with at least either one of the plate-shaped portion 41p and the tubular portion 41t.

As shown in FIG. 4, the rectifying plate 41r partitions the space inside shielding member 41 into an upper space SP1 and a lower space SP2. The upper space SP1 is a portion between the plate-shaped portion 41p and the rectifying plate 41r in a space inside the tubular portion 41t. The lower space SP2 is a portion below the rectifying plate 41r in the space inside the tubular portion 41t. The gas supply port 42 is located above the rectifying plate 41r. The gas discharge port 43 is located below the rectifying plate 41r. The distance in the vertical direction from the lower surface of the plate-shaped portion 41p to the upper surface of the rectifying plate 41r may be equal to or different from the distance in the vertical direction from the lower surface of the rectifying plate 41r to the lower end of the tubular portion 41t.

The rectifying plate 41r is a perforated plate through which a plurality of gas passages 41g pass in the vertical direction. The plurality of gas passages 41g are opened at the upper surface and the lower surface of the rectifying plate 41r. The plurality of gas passages 41g are arranged in the entire region of the rectifying plate 41r. Gas discharged from the gas supply port 42 diffuses in the upper space SP1, and flows downwardly from the upper space SP1 to the lower space SP2 through the plurality of gas passages 41g. Thereby, the gas discharged from the gas supply port 42 is uniformly supplied to the lower space SP2.

The sealed space SP is a space formed by the tubular portion 41t, the plate-shaped portion 41p, and the hot plate 14. The upper space SP1 and the lower space SP2 are included in the sealed space SP. The sealed space SP is a space into and from which a substance cannot enter and exit except for a case in which the substance passes through the gas supply port 42 and the gas discharge port 43. The gas supply port 42 and the gas discharge port 43 are examples of openings through which a gas such as a component gas passes. A gas supply-discharge port also functioning as the gas supply port 42 and as the gas discharge port 43 may be provided in the shielding member 41 instead of the gas supply port 42 and the gas discharge port 43.

The gas supply port 42 is connected to a component gas piping 44p that guides a component gas to be supplied to the shielding member 41 and is connected to an inert gas piping 45p that guides an inert gas to be supplied to the shielding member 41. When a component gas valve 44v attached to the component gas piping 44p is opened, a component gas is discharged from the gas supply port 42. When an inert gas valve 45v attached to the inert gas piping 45p is opened, an inert gas is discharged from the gas supply port 42. FIG. 4 shows an example in which the component gas is an ozone gas (O₃) and the inert gas is a nitrogen gas (N₂). The inert gas piping 45p is an example of a substitution gas piping. The inert gas valve 45v is an example of a substitution gas valve.

The component gas is a gas that generates a processing liquid that processes a substrate W together with a component liquid by causing the component gas to be dissolved in the component liquid or by causing the component gas to react with the component liquid. When the component liquid is sulfuric acid, the component gas may be an ozone gas. In this case, the ozone gas is dissolved in sulfuric acid to generate an SOM (Sulfuric acid and Ozone Mixture) that is ozone-containing sulfuric acid.

The substrate processing apparatus 1 includes a component gas supply source housing a component gas to be supplied to the gas supply port 42 through the component gas piping 44p. When the component gas is an ozone gas, the component gas supply source is an ozone generator 44g that generates an ozone gas. The component gas supply source may be a component gas tank housing a component gas.

The component gas valve 44v is switched between an open state in which a component gas flowing in the component gas piping 44p is allowed to pass through the component gas valve 44v and a closed state in which the component gas valve 44v stops a component gas flowing in the component gas piping 44p. Opening the component gas valve 44v means that the component gas valve 44v is switched from the closed state to the open state. When the component gas valve 44v is opened, the component gas flows from the component gas supply source to the component gas piping 44p and is discharged from the gas supply port 42.

The combination of the component liquid and the component gas is not limited to the sulfuric acid and the ozone gas. The combination of the component liquid and the component gas may be any one among hydrogen peroxide water and ammonia gas (SC1), hydrogen peroxide water and chlorine gas (SC2), sulfuric acid and hydrogen peroxide gas (SPM: Sulfuric acid-hydrogen Peroxide Mixture), pure water and fluorine gas (hydrofluoric acid), and pure water and ammonia gas (ammonium hydroxide), or may be other than these substances. The processing liquids in parentheses, such as SC1, represent processing liquids generated by the component liquid and the component gas. As long as the processing liquid can be generated, the component gas may not be dissolved in the component liquid. In other words, the processing liquid is not limited to a component liquid in which a component gas is dissolved, and may be a component liquid in which a substance generated by a chemical reaction between the component liquid and the component gas on the surface of the component liquid is diffused.

The processing liquid generated by the component liquid and the component gas may be an etching liquid or a liquid other than the etching liquid such as a cleaning liquid. The SOM is an example of the etching liquid. A target object to be processed by the processing liquid generated by both the component liquid and the component gas may be a resist or a target object other than the resist such as amorphous carbon. The target object may be particles or an organic substance.

The gas discharge port 43 is connected to a discharged gas pipe 46p that sucks gas. When a discharged gas valve 46v attached to the discharged gas pipe 46p is opened, gas is sucked from a space inside the shielding member 41 to the gas discharge port 43. The discharged gas pipe 46p may be connected to exhaust facilities provided in a factory in which the substrate processing apparatus 1 is installed, or may be connected to a negative pressure generation source 46s such as a discharged gas pump or an aspirator. FIG. 4 shows an example of the latter.

The discharged gas valve 46v may be a relief valve that automatically maintains the gas pressure in the space inside the shielding member 41 so as to be lower than the set pressure by opening the valve only when the gas pressure in the space inside the shielding member 41 is equal to or higher than the set pressure, or may be an electric valve including an electric actuator that changes the opening degree. The latter example will be hereinafter described. The controller 3 increases or decreases the opening degree of the electric valve by controlling the electric actuator of the electric valve.

When the discharged gas valve 46v is an electric valve, the substrate processing apparatus 1 may include at least either one of a pressure gauge MP that measures the gas pressure in the space inside the shielding member 41 and a concentration gauge MC that measures the concentration of a component gas in the space inside the shielding member 41, or may not include both the pressure gauge MP and the concentration gauge MC.

The controller 3 may perform feedback control that keeps the gas pressure in the sealed space SP constant by increasing or decreasing the opening degree of the discharged gas valve 46v based on the detection value of the pressure gauge MP. The controller 3 may determine whether or not to start the feedback control based on the detection value of the concentration gauge MC. This way makes it possible to keep the gas pressure in the sealed space SP constant while keeping the concentration of the component gas in the sealed space SP so as to be equal to or higher than the set value.

Next, the chuck pin 11 will be described.

FIGS. 5A, 5B, and 5C are schematic views of the chuck pin 11. FIG. 5A shows a state in which the chuck pin 11 is located at the standby position. FIG. 5B shows a state in which the chuck pin 11 is located at the support position. FIG. 5C shows a state in which the chuck pin 11 is located at a gripping position. The upper side of each of FIGS. 5A, 5B, and 5C is a schematic view of the chuck pin 11, which is obtained when the chuck pin 11 is horizontally seen. The lower side of each of FIGS. 5A, 5B, and 5C is a schematic view of the chuck pin 11, which is obtained when the chuck pin 11 is vertically seen.

The plurality of chuck pins 11 horizontally support or hold the substrate W in a state in which the front surface of the substrate W faces in an upward direction. Therefore, the upper surface of the substrate W is a front surface of the substrate W. The substrate W includes a front surface and a rear surface that are parallel to each other, and an annular end surface that connects outer edges of the front and rear surfaces together over the entire circumference of the front and rear surfaces. The front surface of the substrate W is a device formation surface on which a device is formed. The rear surface of the substrate W is a non-device formation surface on which no device is formed. Both the front surface and the rear surface of the substrate W may be device formation surfaces, respectively.

The chuck pin 11 includes a supporting portion 11s that comes into contact with the lower surface of the substrate W, a gripping portion 11g that comes into contact with the end surface of the substrate W, an arm portion 11ar that supports both the supporting portion 11s and the gripping portion 11g, and a rotating portion 11r that vertically extends downwardly from the arm portion 11ar. The rotating portion 11r is located at a position at which the distance in the horizontal direction from the rotational axis A1 (see FIG. 4) of the substrate W exceeds the radius of the substrate W. The supporting portion 11s and the gripping portion 11g are connected to the rotating portion 11r by the arm portion 11ar. The supporting portion 11s, the gripping portion 11g, and the arm portion 11ar are located above the upper surface 12u of the spin base 12.

The chuck pin 11 rotates around the rotating portion 11r with respect to the spin base 12 between an innermost inner position and an outermost standby position. The inner position is a position at which the distance in the horizontal direction from the rotational axis A1 of the substrate W to the supporting portion 11s is less than the radius of the substrate W. The standby position is a position at which the distance in the horizontal direction from the rotational axis A1 of the substrate W to the supporting portion 11s exceeds the radius of the substrate W. The support position and the gripping position are positions between the inner position and the standby position. The support position is a position at which the supporting portion 11s comes into contact with the lower surface of the substrate W without causing the gripping portion 11g to be pressed against the end surface of the substrate W. The gripping position is a position at which the gripping portion 11 g is pressed against the end surface of the substrate W.

The chuck pin 11 may be held at the inner position by an elastic body such as a spring, or may be held at the inner position by a magnetic force. An example of the former will be hereinafter described. The chuck pin 11 is connected to an opening/closing actuator 11a (see FIG. 3) that rotates the chuck pin 11 toward the standby position. The power of the opening/closing actuator 11a may be transmitted to the plurality of chuck pins 11 through a plurality of magnets, or may be transmitted to the plurality of chuck pins 11 through a tangible object such as a link. FIG. 3 shows an example of the former. The opening/closing actuator 11a moves the chuck pin 11 to a position outside the inner position such as the support position and the standby position.

When the force transmitted from the opening/closing actuator 11a to the chuck pin 11 is weakened after the opening/closing actuator 11a moves the chuck pin 11 from the inner position, the chuck pin 11 returns to the inner position by the restoring force of the elastic body. When the force transmitted from the opening/closing actuator 11a to the plurality of chuck pins 11 is weakened in a state in which the substrate W is horizontally supported by the supporting portions 11s of the plurality of chuck pins 11 located at the support position, the plurality of chuck pins 11 move toward the inner position, and the gripping portions 11g of the plurality of chuck pins 11 are pressed against the end surface of the substrate W. Thereby, the plurality of chuck pins 11 are located at the gripping positions, respectively.

Next, an example of processing of the substrate W will be described.

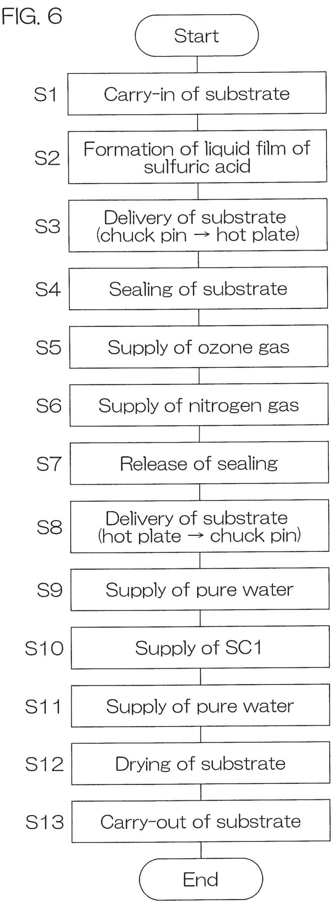

FIG. 6 is a process chart for describing an example of processing of the substrate W performed by the substrate processing apparatus 1. In the following, FIG. 2 to FIG. 4 are referred. FIG. 6 is referred when necessary.

When the substrate W is to be processed by the substrate processing apparatus 1, a carry-in step (step S1 of FIG. 6) of carrying the substrate W into the chamber 4 is performed.

Specifically, in a state in which all the guards 34 are located at the lower position, all the scan nozzles are located at the standby position, the shielding member 41 is located at the upper position, the hot plate 14 is located at the lower position, and the plurality of chuck pins 11 are located at the support position, the center robot CR (see Fig. 1A) moves the hand Hc into the chamber 4 while horizontally supporting the substrate W with the hand Hc such that the front surface of the substrate W faces in the upward direction. Thereafter, the center robot CR places the substrate W, which is present on the hand Hc, on the supporting portions 11s of the plurality of chuck pins 11 located at the support position (see Fig. 5B). Thereafter, the center robot CR moves the hand Hc out of the chamber 4.

When the substrate W on the hand Hc is placed on the supporting portions 11s of the plurality of chuck pins 11 located at the support position, the plurality of supporting portions 11s come into contact with the lower surface of the substrate W in a state in which the plurality of gripping portions 11g are separated from the end surface of the substrate W (see FIG. 5B). Thereby, the substrate W is horizontally supported by the plurality of chuck pins 11. Thereafter, the opening/closing actuator 11a moves the plurality of chuck pins 11 from the support position to the gripping position. Thereby, the plurality of gripping portions 11g are pressed against the end surface of the substrate W, and the substrate W is held horizontally (see FIG. 5C). In other words, the substrate W is fixed to the plurality of chuck pins 11, and the substrate W is prevented from moving to the plurality of chuck pins 11.

Thereafter, a first chemical liquid supplying step of supplying an SOM, which is an example of the first chemical liquid, to the upper surface of the substrate W is performed.

Specifically, the spin motor 13 rotates the substrate W held by the plurality of chuck pins 11. Simultaneously with or before or after the start of the rotation of the substrate W, the first nozzle actuator 21a moves the first chemical liquid nozzle 21 from the standby position to the processing position. Thereby, the first chemical liquid nozzle 21 is located between the shielding member 41 and the substrate W. Thereafter, the first chemical liquid valve 21v is opened. Thereby, the first chemical liquid nozzle 21 starts discharging sulfuric acid. The guard raising/lowering actuator 34a raises at least one guard 34 from the lower position to the upper position before the discharge of sulfuric acid is started.

The sulfuric acid discharged from the first chemical liquid nozzle 21 collides with the upper surface of the substrate W rotating at a first chemical liquid supply speed, and then spreads along the upper surface of the substrate W. Thereby, the entire upper surface of the substrate W held by the plurality of chuck pins 11 is covered with a liquid film of sulfuric acid (step S2 in FIG. 6). Thereafter, the first chemical liquid valve 21v is closed, and the first chemical liquid nozzle 21 stops the discharge of sulfuric acid. The first nozzle actuator 21a moves the first chemical liquid nozzle 21 from the processing position to the standby position in a state in which the first chemical liquid nozzle 21 is not discharging sulfuric acid.

When the first chemical liquid nozzle 21 is discharging sulfuric acid, the first nozzle actuator 21a may move the collision position such that the collision position of sulfuric acid with respect to the upper surface of the substrate W passes through the central portion and the outer peripheral portion, or may stop the collision position at the central portion. The same applies to the time when a processing liquid other than sulfuric acid is discharged toward the upper surface of the substrate W.

After the entire upper surface of the substrate W is covered with a liquid film of sulfuric acid, the spin motor 13 stops the substrate W held by the plurality of chuck pins 11. Thereafter, the opening/closing actuator 11a moves the plurality of chuck pins 11 from the gripping position to the support position. This releases the substrate W from being fixed to the plurality of chuck pins 11. Thereafter, the raising/lowering actuator 14a moves the hot plate 14 from the lower position to the upper position. Thereby, in a state in which the entire upper surface of the substrate W is covered with the liquid film of sulfuric acid, the substrate W is lifted up by the hot plate 14 and is separated upwardly from the plurality of chuck pins 11 (step S3 of FIG. 6). The substrate W is heated by the hot plate 14. The heat generation of the hot plate 14 may be started at the same time as the hot plate 14 comes into contact with the lower surface of the substrate W, or may be started before or after its contact with the lower surface of the substrate W. When the hot plate 14 heats the substrate W, the temperature of the hot plate 14 may be lower than 100°C or 100°C or higher.

After the substrate W is lifted up by the hot plate 14, the opening/closing actuator 11a moves the plurality of chuck pins 11 from the support position to the standby position. Thereby, the plurality of chuck pins 11 are located at positions not coinciding with the shielding member 41 in a plan view. Thereafter, the raising/lowering actuator 41a moves the shielding member 41 from the upper position to the lower position. Thereby, a gap between the lower surface of the tubular portion 41t of the shielding member 41 and the upper surface of the hot plate 14 is sealed, and a sealed space SP (see FIG. 4) housing the substrate W is formed between the shielding member 41 and the hot plate 14 (step S4 of FIG. 6). When the shielding member 41 is located at the lower position, the substrate W is located above the lower end of the tubular portion 41t of the shielding member 41, and is surrounded by the tubular portion 41t of the shielding member 41. The space inside the shielding member 41 is partitioned into an upper space SP1 and a lower space SP2 by the rectifying plate 41r. The substrate W is located in the lower space SP2 in a state of being separated downwardly from the rectifying plate 41r.

After the space housing the substrate W is sealed, the component gas valve 44v and the discharged gas valve 46v are opened. When the component gas valve 44v is opened, an ozone gas is supplied to the space between the shielding member 41 and the hot plate 14 through the gas supply port 42 (step S5 if FIG. 6). When the discharged gas valve 46v is opened, gas is discharged from the space between the shielding member 41 and the hot plate 14 through the gas discharge port 43. If there is a period during which both the component gas valve 44v and the discharged gas valve 46v are open, the component gas valve 44v and the discharged gas valve 46v may be opened simultaneously with each other or at different times, respectively.

Immediately after the component gas valve 44v and the discharged gas valve 46v are opened, air is discharged from the space between the shielding member 41 and the hot plate 14 while ozone gas is being supplied to the space between the shielding member 41 and the hot plate 14. When the supply of ozone gas and the discharge of air are continued, air between the shielding member 41 and the hot plate 14 is replaced with ozone gas. Thereby, the space between the shielding member 41 and the hot plate 14 is filled with the ozone gas.

The gas pressure in the space housing the substrate W, i.e., the pressure of the ozone gas in the space between the shielding member 41 and the hot plate 14 is kept at a value higher than the gas pressure in the space in the chamber 4 excluding the space between the shielding member 41 and the hot plate 14. If this is satisfied, the supply of ozone gas to the space between the shielding member 41 and the hot plate 14 and the discharge of gas from that space may be stopped or continued. In the latter case, the gas pressure in the space between the shielding member 41 and the hot plate 14 may be kept constant by changing the pressure loss of the gas upstream or downstream of the space between the shielding member 41 and the hot plate 14. FIG. 7 described later shows an example in which the pressure loss of gas is changed downstream of the space between the shielding member 41 and the hot plate 14 by changing the opening degree of the discharged gas valve 46v.

Sulfuric acid is an example of a component liquid, and ozone gas is an example of a component gas. When ozone gas is supplied to the space between the shielding member 41 and the hot plate 14 in a state in which the entire upper surface of the substrate W is covered with a liquid film of sulfuric acid, the ozone gas comes into contact with the liquid film of sulfuric acid on the substrate W and is dissolved in the sulfuric acid. Thereby, an SOM can be supplied to the entire upper surface of the substrate W. A target object to be etched that has been exposed on the upper surface of the substrate W comes into contact with the SOM on the substrate W. This enables the to-be-etched target object, such as a resist film, to be etched by the SOM.

The SOM on the substrate W is heated by the hot plate 14 through the substrate W. The SOM produces peroxodisulfate ions in the SOM. The peroxodisulfate ion changes into a sulfate ion radical having strong oxidizing power. The application of thermal energy to the SOM makes it possible to promote a change to a sulfate ion radical. This makes it possible to enhance the reactivity of the SOM, and makes it possible to shorten a period of time required for etching the to-be-etched target object.

The amount of ozone gas dissolved, i.e., the amount of ozone gas soluble in sulfuric acid depends on the concentration and the pressure of ozone gas. The space between the shielding member 41 and the hot plate 14 is filled with ozone gas, and the pressure of the ozone gas in this space is kept at a value higher than the gas pressure in the space in the chamber 4 excluding the space between the shielding member 41 and the hot plate 14, and therefore both the concentration and the pressure of the ozone gas are high. In particular, the space housing the substrate W is sealed, and therefore it is possible to increase the concentration and pressure of the ozone gas to a higher value than when the space is not sealed.

When a predetermined time elapses after the supply of an ozone gas to the space between the shielding member 41 and the hot plate 14 is started, the ozone gas between the shielding member 41 and the hot plate 14 is replaced with a gas other than the ozone gas such as an inert gas. Specifically, when the supply of an ozone gas to the space between the shielding member 41 and the hot plate 14 and the discharge of a gas from this space are stopped, the discharged gas valve 46v is opened to restart the discharge of the gas. When the supply of the ozone gas to the space between the shielding member 41 and the hot plate 14 and the discharge of the gas from this space are continued, the component gas valve 44v is closed, and the supply of the ozone gas is stopped while the discharge of the gas is being continued.

The inert gas valve 45v is opened in a state in which the supply of the ozone gas to the space between the shielding member 41 and the hot plate 14 is stopped and the gas is being discharged from this space. Thereby, the supply of the nitrogen gas to the space between the shielding member 41 and the hot plate 14 is started (step S6 of FIG. 6). The nitrogen gas is an example of a replacement gas different from a component gas. When the supply of the nitrogen gas and the discharge of the gas are continued, the ozone gas between the shielding member 41 and the hot plate 14 is replaced with the nitrogen gas, and the space between the shielding member 41 and the hot plate 14 is filled with the nitrogen gas. Thereafter, the inert gas valve 45v and the discharged gas valve 46v are closed to stop the supply of the nitrogen gas and the discharge of the gas.

Thereafter, a first rinse liquid supplying step of supplying pure water, which is an example of a rinse liquid, to the upper surface of the substrate W is performed.

Specifically, the raising/lowering actuator 41a moves the shielding member 41 from the lower position to the upper position. Thereby, the lower end of the tubular portion 41t of the shielding member 41 is located above the upper end of the chuck pin 11, and the sealing of the space housing the substrate W is released (step S7 of FIG. 6). Thereafter, the opening/closing actuator 11a moves the plurality of chuck pins 11 from the standby position to the support position. Thereafter, the raising/lowering actuator 14a moves the hot plate 14 from the upper position to the lower position. Thereby, in a state in which the entire upper surface of the substrate W is covered with an SOM liquid film, the substrate W present on the hot plate 14 is placed on the supporting portions 11s of the plurality of chuck pins 11, and the hot plate 14 is separated downwardly from the substrate W (step S8 of FIG. 6). Thereafter, the opening/closing actuator 11a moves the plurality of chuck pins 11 from the support position to the gripping position.

After the plurality of chuck pins 11 move to the gripping position, the spin motor 13 rotates the substrate W held by the plurality of chuck pins 11. Simultaneously with or before or after the rotation of the substrate W is started, the third nozzle actuator 23a moves the rinse liquid nozzle 23 from the standby position to the processing position. Thereby, the rinse liquid nozzle 23 is located between the shielding member 41 and the substrate W. Thereafter, the rinse liquid valve 23v is opened. Thereby, the rinse liquid nozzle 23 starts discharging pure water. The guard raising/lowering actuator 34a may switch the guard 34, which receives a liquid discharged from the substrate W, by vertically moving at least one guard 34 before the discharge of the pure water is started. The same applies to a second chemical liquid supplying step and the like described later.

The pure water discharged from the rinse liquid nozzle 23 collides with the upper surface of the substrate W rotating at a first rinse liquid supply speed, and then spreads along the upper surface of the substrate W. Thereby, the SOM present on the substrate W is replaced with the pure water, and the entire upper surface of the substrate W held by the plurality of chuck pins 11 is covered with a liquid film of the pure water (step S9 of FIG. 6). Thereafter, the rinse liquid valve 23v is closed, and the rinse liquid nozzle 23 stops discharging pure water. The third nozzle actuator 23a moves the rinse liquid nozzle 23 from the processing position to the standby position in a state in which the rinse liquid nozzle 23 is not discharging pure water.

Thereafter, the second chemical liquid supplying step (step S10 of FIG. 6) of supplying SC1, which is an example of the second chemical liquid, to the upper surface of the substrate W is performed.

Specifically, the second nozzle actuator 22a moves the second chemical liquid nozzle 22 from the standby position to the processing position in a state in which the substrate W is held by the plurality of chuck pins 11 and in which the shielding member 41 is located at the upper position. Thereafter, the second chemical liquid valve 22v is opened. Thereby, the second chemical liquid nozzle 22 starts discharging SC1. SC1 discharged from the second chemical liquid nozzle 22 collides with the upper surface of the substrate W rotating at a second chemical solution supply speed, and then spreads along the upper surface of the substrate W. Thereby, the pure water present on the substrate W is replaced with SC1, and the entire upper surface of the substrate W held by the plurality of chuck pins 11 is covered with a liquid film of SC1. Thereafter, the second chemical liquid valve 22v is closed, and the second chemical liquid nozzle 22 stops discharging SC1. The second nozzle actuator 22a moves the second chemical liquid nozzle 22 from the processing position to the standby position in a state in which the second chemical liquid nozzle 22 is not discharging SC1.

Thereafter, a second rinse liquid supplying step (step S11 of FIG. 6) of supplying pure water, which is an example of the rinse liquid, to the upper surface of the substrate W is performed.

Specifically, in a state in which the substrate W is held by the plurality of chuck pins 11 and in which the shielding member 41 is located at the upper position, the third nozzle actuator 23a moves the rinse liquid nozzle 23 from the standby position to the processing position. Thereafter, the rinse liquid valve 23v is opened. Thereby, the rinse liquid nozzle 23 starts discharging a rinse liquid. The rinse liquid discharged from the rinse liquid nozzle 23 collides with the upper surface of the substrate W rotating at a second rinse liquid supply speed, and then spreads along the upper surface of the substrate W. Thereby, SC1 present on the substrate W is replaced with pure water, and the entire upper surface of the substrate W held by the plurality of chuck pins 11 is covered with a liquid film of the pure water. Thereafter, the rinse liquid valve 23v is closed, and the rinse liquid nozzle 23 stops discharging pure water. The third nozzle actuator 23a moves the rinse liquid nozzle 23 from the processing position to the standby position in a state in which the rinse liquid nozzle 23 is not discharging pure water.

Thereafter, a drying step (step S12 of FIG. 6) of drying the substrate W by the rotation of the substrate W is performed.

Specifically, the spin motor 13 accelerates the substrate W in the rotation direction in a state in which the substrate W is held by the plurality of chuck pins 11. Thereby, the substrate W rotates at a drying speed higher than the rotation speed when a processing liquid, such as the first chemical liquid, is supplied to the substrate W. The substrate W rotates at the drying speed, and, as a result, the liquid is removed from the substrate W, and the substrate W is dried. Thereafter, the spin motor 13 stops the rotation. Thereby, the rotation of the substrate W is stopped in a state in which the substrate W is held by the plurality of chuck pins 11.

Thereafter, a carry-out step of carrying out the substrate W from the chamber 4 is performed (step S13 of FIG. 6).

Specifically, the opening/closing actuator 11a moves the plurality of chuck pins 11 from the gripping position to the support position. Simultaneously with or before or after the substrate W is released from being fixed to the plurality of chuck pins 11, the guard raising/lowering actuator 34a lowers all the guards 34 to the lower position. Thereafter, the center robot CR (see FIG. 1A) moves the hand Hc into the chamber 4. Thereafter, the center robot CR lifts the substrate W supported by the plurality of chuck pins 11 with the hand Hc. Thereafter, the center robot CR moves the hand Hc to the outside of the chamber 4 while horizontally supporting the substrate W with the hand Hc. Thereby, the already-processed substrate W is carried out from the chamber 4.

Next, an example of a change in the gas pressure in the sealed space SP will be described.

FIG. 7 is a timing chart for describing a flow from when a space housing the substrate W is sealed to when an ozone gas in the space is replaced with a nitrogen gas in the example of the processing of the substrate W shown in FIG. 6. Reference is made to FIG. 4 and FIG. 7 in the following description.

ON of "Sealing of substrate" in FIG. 7 denotes that the space housing the substrate W is sealed, and OFF of "Sealing of substrate" in FIG. 7 denotes that the space housing the substrate W is not sealed. The initial value of "Air pressure in sealed space" in FIG. 7 represents the gas pressure in the chamber 4. The initial value may be the atmospheric pressure (1 atm), or may be a value higher or lower than the atmospheric pressure.

ON of "Supply of ozone gas" in FIG. 7 denotes that an ozone gas is supplied to the space between the shielding member 41 and the hot plate 14, and OFF of "Supply of ozone gas" in FIG. 7 denotes that an ozone gas is not supplied to the space between the shielding member 41 and the hot plate 14. The same applies to ON and OFF of "Supply of nitrogen gas" in FIG. 7. The fully open state of the "Discharged gas valve 46v" in FIG. 7 denotes that the opening degree of the discharged gas valve 46v is the maximum, and the fully closed state of the "Discharged gas valve 46v" in FIG. 7 denotes that the opening degree of the discharged gas valve 46v is the minimum.

In an example shown in FIG. 7, a gap between the shielding member 41 and the hot plate 14 is sealed at time T1. Thereby, the space housing the substrate W is sealed. The component gas valve 44v is opened at time T1. Thereby, the supply of an ozone gas to the sealed space SP is started. The discharged gas valve 46v is opened to the maximum opening degree at time T1. Although the supply of the ozone gas to the sealed space SP is started, a gas is discharged from the sealed space SP, and therefore the gas pressure in the sealed space SP is kept at a value equal to or substantially equal to the initial value from time T1 to time T2.

The discharged gas valve 46v is closed to an opening degree larger than the minimum opening degree (0) at time T2. Thereby, the gas pressure in the sealed space SP increases and is kept at a constant or substantially constant value exceeding the initial value from time T2 to time T3. An SOM is generated on the upper surface of the substrate W, and the substrate W is processed between time T2 and time T3 as described above. The component gas valve 44v is closed at time T3. The discharged gas valve 46v is opened to the maximum opening degree at time T3. Thereby, the gas pressure in the sealed space SP decreases while the sealed space SP is filled with the ozone gas. FIG. 7 shows an example in which the gas pressure in the sealed space SP has decreased to the initial value.

The inert gas valve 45v is opened at time T4. Thereby, the supply of a nitrogen gas to the sealed space SP is started. The inert gas valve 45v is kept in an open state from time T4 to time T5. The opening degree of the discharged gas valve 46v is maximum between time T4 and time T5. Therefore, the ozone gas in the sealed space SP is quickly replaced with the nitrogen gas. The inert gas valve 45v and the discharged gas valve 46v are closed at time T5. The shielding member 41 moves from the lower position at time T5. Thereby, the space housing the substrate W is opened. Thereafter, pure water is supplied to the upper surface of the substrate W (step S9 of FIG. 6).

Next, the advantages according to the preferred embodiment will be described.

In the preferred embodiment, a component liquid, such as sulfuric acid, is supplied to the upper surface of the substrate W. Thereafter, a gap between the shielding member 41 and the hot plate 14 is sealed in a state in which the component liquid is present on the upper surface of the substrate W. Thereby, a sealed space SP housing the substrate W held by the hot plate 14 is formed between the shielding member 41 and the hot plate 14. In this state, a component gas, such as ozone gas, is supplied to the sealed space SP. Thereby, the gas pressure in the sealed space SP increases to a value higher than the gas pressure outside the sealed space SP in a state in which the component liquid is present on the upper surface of the substrate W. For example, the gas pressure in the sealed space SP increases to a higher value than a value when the space housing the substrate W is not sealed.

When the component gas is supplied to the sealed space SP, the concentration of the component gas in the sealed space SP increases. When the gas pressure in the sealed space SP is increased to a value higher than the gas pressure outside the sealed space SP, the concentration of the component gas in the sealed space SP further increases. The concentration and pressure of the component gas in the sealed space SP are high, thus making it possible to efficiently generate a processing liquid containing a component liquid and a component gas on the upper surface of the substrate W.

For example, when the component gas is dissolved in the component liquid, it possible to increase the amount and the velocity of dissolution of the component gas as compared to a case in which the concentration and the pressure of the component gas in the sealed space SP are low. When a substance to process the substrate W is generated by the chemical reaction of the component liquid and the component gas, the number of molecules or atoms of the component gas present in the sealed space SP is large as compared to a case in which the concentration and the pressure of the component gas present in the sealed space SP are low, thus making it possible to increase the number of molecules or atoms of the component gas reacting with the component liquid. This makes it possible to efficiently generate a substance to process the substrate W in the component liquid.

In the preferred embodiment, a component gas is continuously supplied to the sealed space SP while discharging a gas from the sealed space SP. In other words, the gas pressure in the sealed space SP is kept at a value higher than the gas pressure outside the sealed space SP while the component gas in the sealed space SP is continuously replaced with a new component gas. Therefore, it is possible to more efficiently supply a new component gas to the component liquid present on the substrate W, and is possible to improve the fluidity of the component gas in the sealed space SP as compared to a case in which the gas pressure in the sealed space SP is kept at a value higher than the gas pressure outside the sealed space SP while the supply of the component gas to the sealed space SP is stopped.

In the preferred embodiment, a component liquid is discharged toward the upper surface of the substrate W held by the spin chuck 10 while causing the spin chuck 10 to rotate the substrate W. This makes it possible to uniformly supply the component liquid to the upper surface of the substrate W. In this state, the spin chuck 10 and the hot plate 14 are relatively moved, and, as a result, the substrate W is moved from the spin chuck 10 to the hot plate 14. Thereafter, the hot plate 14 heats the substrate W while holding the substrate W in a state in which the component liquid is present on the upper surface of the substrate W and the gas pressure in the sealed space SP is higher than the gas pressure outside the sealed space SP. This makes it possible to bring the component gas into contact with the component liquid on the substrate W while heating the substrate W and the component liquid. As a result, it is possible to increase the temperature of the processing liquid containing the component liquid and the component gas, and is possible to heighten the reactivity of the processing liquid.

In the preferred embodiment, not the gap between the shielding member 41 and the spin chuck 10 but the gap between the shielding member 41 and the hot plate 14 is sealed, and, as a result, a sealed space SP housing the substrate W held by the hot plate 14 is formed between the shielding member 41 and the hot plate 14. The spin chuck 10 horizontally holds the substrate W with the plurality of chuck pins 11 arranged around the substrate W. When the gap between the shielding member 41 and the spin chuck 10 is sealed, it is necessary to seal the gap outside the plurality of chuck pins 11. Therefore, it is possible to make the shielding member 41 smaller in size as compared to a case in which the gap between the shielding member 41 and the spin chuck 10 is sealed.

In the preferred embodiment, the component gas is diffused into the upper space SP1 formed by the tubular portion 41t, the plate-shaped portion 41p, and the rectifying plate 41r of the shielding member 41. The component gas in the upper space SP1 passes through the plurality of gas passages 41g that vertically penetrate the rectifying plate 41r, and the component gas flows to the lower space SP2 that is a portion of the space inside the tubular portion 41t of the shielding member 41 and that is located below the rectifying plate 41r. When the sealed space SP is formed between the shielding member 41 and the hot plate 14, the substrate W is located in the lower space SP2. Therefore, it is possible to uniformly supply the component gas to the component liquid present on the substrate W as compared to a case in which the rectifying plate 41r is not provided.

In the preferred embodiment, the component gas is supplied to the sealed space SP, and, as a result, the gas pressure in the sealed space SP is increased to a value higher than the gas pressure outside the sealed space SP and then the component gas is discharged from the sealed space SP, thus decreasing the gas pressure inside the sealed space SP. Thereafter, a replacement gas other than the component gas, such as an inert gas or air, is supplied to the sealed space SP while discharging the component gas from the sealed space SP in a state in which the sealed space SP is filled with the component gas and in which the gas pressure in the sealed space SP has decreased. Thereby, the component gas in the sealed space SP is replaced with the replacement gas. When the replacement gas is supplied to the sealed space SP in a state in which the gas pressure in the sealed space SP is high, there is a case in which a reverse flow occurs, i.e., the component gas in the sealed space SP flows to a path along which the replacement gas is supplied. Such a reverse flow can be prevented by lowering the gas pressure in the sealed space SP.

In the preferred embodiment, the gap between the shielding member 41 and the hot plate 14 is sealed in the chamber 4. Thereby, a sealed space SP housing the substrate W held by the hot plate 14 is formed between the shielding member 41 and the hot plate 14. The component gas is not supplied to the entire space in the chamber 4, but is supplied only to the space between the shielding member 41 and the hot plate 14, which is a portion of the space in the chamber 4. Therefore, it is possible to narrow a range in which the component gas is diffused, and is possible to reduce the amount of the component gas used.

Next, other preferred embodiments will be described

The sealed space SP housing the substrate W may be formed between the shielding member 41 and the hot plate 14 by moving only the hot plate 14 or both the shielding member 41 and the hot plate 14 instead of moving the shielding member 41 with respect to the hot plate 14.

The sealed space SP housing the substrate W may be formed between the shielding member 41 and the spin base 12 by sealing not the gap between the shielding member 41 and the hot plate 14 but the gap between the shielding member 41 and the spin base 12.

One of the spin chuck 10 and the hot plate 14 may be omitted.

The substrate W may be continuously held by the spin chuck 10 until the substrate W is dried after the supply of a processing liquid to the substrate W is started. That is, the substrate W may not be moved from the spin chuck 10 to the hot plate 14. In this case, the substrate W may be heated by the hot plate 14 in a state in which the hot plate 14 is separated from the substrate W.

As shown in Fig. 8, the component gas, such as ozone gas, may be supplied to the space between the shielding member 41 and the hot plate 14 in a state in which the gap G1 between the shielding member 41 and the hot plate 14 is not sealed.

In the example shown in Fig. 8, an ozone gas is supplied to the space between the shielding member 41 and the hot plate 14 in a state in which the gap G1 between the shielding member 41 and the hot plate 14 is not sealed. The pressure of the ozone gas moves a gas between the shielding member 41 and the hot plate 14 toward the gap G1. Thereby, this gas is discharged through the gap G1. Even when one or more gas discharge ports 43 (see FIG. 4) are provided in the shielding member 41, it is difficult to make the opening area of the gas discharge port 43 (area of a cross section along a plane perpendicular to a direction in which the gas flows) larger than the opening area of the gap G1. Therefore, it is possible to quickly replace the gas between the shielding member 41 and the hot plate 14 with the ozone gas before the gap G1 is sealed.

The upper end 34u of the guard 34 surrounds the shielding member 41 and the hot plate 14 in a plan view. When a component gas is supplied to the space between the shielding member 41 and the hot plate 14 in a state in which the gap G1 is not sealed, the gas in the guard 34 may be discharged through the discharged gas duct 8 located below the gap G1 while the upper end 34u of the guard 34 is positioned above the gap G1 as shown in FIG. 8. In this way, the gas that has exited from the gap G1 flows downwardly in the space inside the guard 34 toward the discharged gas duct 8 and is sucked into the discharged gas duct 8. Therefore, it is possible to narrow a range in which the gas discharged from the gap G1 is diffused.

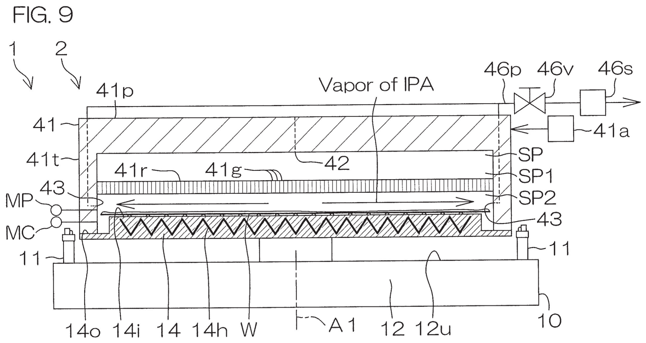

The substrate W to which not pure water but a liquid of an organic solvent having higher volatility than water adheres may be dried. A substrate W to which isopropyl alcohol (IPA), which is an example of an organic solvent, adheres may be dried as shown in FIG. 9. In this case, an organic solvent supplying step of supplying IPA, which is an example of an organic solvent, to the upper surface of the substrate W may be performed after performing the second rinse liquid supplying step (step S11 of FIG. 6) and before performing the drying step (step S12 of FIG. 6).

Specifically, an organic solvent nozzle 24 (see FIG. 3) may discharge IPA (liquid; the same applies hereinafter) toward the upper surface of the substrate W while the substrate W is rotated by the spin chuck 10. FIG. 3 shows an example in which an organic solvent piping 24p to which the organic solvent valve 24v is attached is connected to the organic solvent nozzle 24, and a fourth nozzle actuator 24a horizontally moves the organic solvent nozzle 24 between the processing position and the standby position. In a case in which the IPA is supplied to the substrate W, a dedicated guard 34 (see FIG. 3) that receives the IPA scattered from the substrate W may be provided.

After the entire upper surface of the substrate W is covered with a liquid film of an organic solvent, such as IPA, the substrate W is moved from the spin chuck 10 to the hot plate 14 by relatively moving the spin chuck 10 and the hot plate 14 in this state. Thereafter, the gap between the shielding member 41 and the hot plate 14 is sealed, and, as a result, a sealed space SP housing the substrate W held by the hot plate 14 is formed between the shielding member 41 and the hot plate 14. Before moving the substrate W from the spin chuck 10 to the hot plate 14, the thickness of the liquid film of the organic solvent may be reduced in a state in which the entire upper surface of the substrate W is covered with the liquid film of the organic solvent by rotating the substrate W.

After the sealed space SP is formed, the discharged gas valve 46v is opened in a state in which the liquid of the organic solvent is present on the upper surface of the substrate W, and the gas in the sealed space SP is discharged to the discharged gas pipe 46p through the gas discharge port 43 as shown in FIG. 9. Thereby, the gas pressure in the sealed space SP decreases to, for example, a value less than the atmospheric pressure. The organic solvent is a substance having higher volatility than water. When the gas pressure in the sealed space SP is reduced in a state in which the liquid of the organic solvent is present on the upper surface of the substrate W, evaporation of the organic solvent is promoted. Thereby, the organic solvent present on the substrate W gradually decreases and disappears from the upper surface of the substrate W. In other words, the substrate W is dried while being stationary. Therefore, it is also possible to dry the substrate W by using the sealed space SP.

An object to be processed by a processing liquid produced by the component liquid and the component gas may be molybdenum trioxide. In other words, digital etching may be performed as described in Japanese Patent Application Publication No. 2024-018601. In this case, the ammonia gas may be discharged from the gas supply port 42 in a state in which the upper surface of the substrate W is covered with a liquid film of pure water after supplying the oxygen gas or the ozone gas discharged from the gas supply port 42 to the upper surface of the substrate W. In this way, a bulk layer of a molybdenum film covered with a surface layer of the molybdenum film is not changed to a molybdenum trioxide film, and the surface layer of the molybdenum film is changed to the molybdenum trioxide film by the oxygen gas or the ozone gas. Thereafter, the molybdenum trioxide film is etched by ammonium hydroxide, and the bulk layer of the molybdenum film is exposed. This is repeated, and, as a result, the thickness of the molybdenum film decreases stepwise.

The substrate processing apparatus 1 is not restricted to an apparatus to process a disc-shaped substrate W, and may be an apparatus to process a polygonal substrate W.

Two or more arrangements among all the arrangements described above may be combined. Two or more steps among all the steps described above may be combined.

The preferred embodiments of the present invention are described in detail above, however, these are just detailed examples used for clarifying the technical contents of the present invention, and the present invention should not be limitedly interpreted to these detailed examples, and the spirit and scope of the present invention should be limited only by the claims appended hereto.

## Claims

1. A substrate processing method comprising:
causing a substrate holder to horizontally hold a substrate (W);
supplying a component liquid to an upper surface of the substrate (W) held by the substrate holder;
forming a sealed space (SP) housing the substrate (W) held by the substrate holder between a shielding member (41) and the substrate holder by sealing a gap between the shielding member (41) and the substrate holder in a state in which the component liquid is present on the upper surface of the substrate (W); and
increasing gas pressure in the sealed space (SP) to a value higher than gas pressure outside the sealed space (SP) by supplying a component gas, which generates a processing liquid together with the component liquid, to the sealed space (SP) in a state in which the component liquid is present on the upper surface of the substrate (W).

2. The substrate processing method according to claim 1, wherein increasing the gas pressure in the sealed space (SP) includes keeping the gas pressure in the sealed space (SP) at a value higher than the gas pressure outside the sealed space (SP) by continuously supplying the component gas to the sealed space (SP) while discharging gas from the sealed space (SP) in a state in which the component liquid is present on the upper surface of the substrate (W).

3. The substrate processing method according to claim 1 or 2, wherein the substrate holder includes a spin chuck (10) that rotates the substrate (W) while horizontally holding the substrate (W) by a plurality of chuck pins (11) arranged around the substrate (W), and a hot plate (14) that heats the substrate (W) while horizontally holding the substrate (W);
the substrate processing method further includes moving the substrate (W) between the spin chuck (10) and the hot plate (14) by relatively moving the spin chuck (10) and the hot plate (14);
supplying the component liquid includes discharging the component liquid toward the upper surface of the substrate (W) held by the spin chuck (10) while causing the spin chuck (10) to rotate the substrate (W); and
increasing the gas pressure in the sealed space (SP) includes causing the hot plate (14) to heat the substrate (W) while holding the substrate (W) in a state in which the component liquid is present on the upper surface of the substrate (W) and the gas pressure in the sealed space (SP) is higher than the gas pressure outside the sealed space (SP).

4. The substrate processing method according to claim 3, wherein forming the sealed space (SP) includes forming the sealed space (SP) housing the substrate (W) held by the hot plate (14) between the shielding member (41) and the hot plate (14) by sealing the gap between the shielding member (41) and the hot plate (14) in a state in which the component liquid is present on the upper surface of the substrate (W).

5. The substrate processing method according to any one of claims 1 to 4, wherein increasing the gas pressure in the sealed space (SP) includes:
diffusing the component gas into an upper space (SP1) that is a portion of a space inside a tubular portion (41t) of the shielding member (41) surrounding the substrate (W) held by the substrate holder in a state in which the sealed space (SP) has been formed, the portion being located between a rectifying plate (41r) of the shielding member (41) located above the substrate (W) held by the substrate holder and a plate-shaped portion (41p) of the shielding member (41) located above the rectifying plate (41r); and
supplying the component gas existing in the upper space (SP1) to a lower space (SP2) that is a portion of the space inside the tubular portion (41t) of the shielding member (41) and that is a space below the rectifying plate (41r) through a plurality of gas passages (41g) vertically penetrating the rectifying plate (41r).

6. The substrate processing method according to any one of claims 1 to 5, further comprising:
reducing the gas pressure in the sealed space (SP) by discharging the component gas from the sealed space (SP); and
supplying replacement gas, which is gas other than the component gas, to the sealed space (SP) after the gas pressure in the sealed space (SP) decreases in a state in which the sealed space (SP) is filled with the component gas and the component gas is discharged from the sealed space (SP).

7. The substrate processing method according to any one of claims 1 to 6, further comprising pressurization preparation to discharge gas in the space between the shielding member (41) and the substrate holder through the gap by supplying the component gas to the space between the shielding member (41) and the substrate holder in a state in which the gap between the shielding member (41) and the substrate holder is not sealed.

8. The substrate processing method according to claim 7, wherein the pressurization preparation includes discharging gas in a guard (34) through a discharged gas duct located below the gap between the shielding member (41) and the substrate holder while positioning an upper end (34u) of the guard (34) surrounding the shielding member (41) and the substrate holder in a plan view above the gap when the component gas is supplied to the space between the shielding member (41) and the substrate holder in a state in which the gap is not sealed.

9. The substrate processing method according to any one of claims 1 to 8, further comprising:
supplying a liquid of an organic solvent having higher volatility than water to the upper surface of the substrate (W) held by the substrate holder after supplying the component gas to the sealed space (SP); and
evaporating the liquid of the organic solvent on the upper surface of the substrate (W) until the upper surface of the substrate (W) is dried by discharging gas from the sealed space (SP) to reduce the gas pressure in the sealed space (SP) in a state in which the liquid of the organic solvent is present on the upper surface of the substrate (W).

10. The substrate processing method according to any one of claims 1 to 9, wherein forming the sealed space (SP) is forming the sealed space (SP) housing the substrate (W) held by the substrate holder between the shielding member (41) and the substrate holder by sealing the gap between the shielding member (41) and the substrate holder in a chamber (4) housing the shielding member (41) and the substrate holder in a state in which the component liquid is present on the upper surface of the substrate (W).

11. A substrate processing apparatus (1) comprising:
a substrate holder that horizontally holds a substrate (W);
a component liquid nozzle (21) that discharges a component liquid toward an upper surface of the substrate (W) held by the substrate holder;
a shielding member (41);
a relative movement actuator (41a) that forms a sealed space (SP) housing the substrate (W) held by the substrate holder between the shielding member (41) and the substrate holder by reducing a distance between the shielding member (41) and the substrate holder and by sealing a gap between the shielding member (41) and the substrate holder in a state in which the component liquid is present on the upper surface of the substrate (W); and
a component gas piping (44p) that increases gas pressure in the sealed space (SP) to a value higher than gas pressure outside the sealed space (SP) by supplying a component gas, which generates a processing liquid together with the component liquid, to the sealed space (SP) in a state in which the component liquid is present on the upper surface of the substrate (W).

12. The substrate processing apparatus (1) according to claim 11, further comprising a discharged gas pipe (46p) that sucks gas in a space between the shielding member (41) and the substrate holder, wherein
the component gas piping (44p) keeps the gas pressure in the sealed space (SP) at a value higher than the gas pressure outside the sealed space (SP) by continuously supplying the component gas to the sealed space (SP) when the discharged gas pipe (46p) is discharging gas from the sealed space (SP) in a state in which the component liquid is present on the upper surface of the substrate (W).

13. The substrate processing apparatus (1) according to claim 11 or 12, wherein the substrate holder includes a spin chuck (10) that rotates the substrate (W) while horizontally holding the substrate (W) by a plurality of chuck pins (11) arranged around the substrate (W) and a hot plate (14) that heats the substrate (W) while horizontally holding the substrate (W);
the substrate processing apparatus (1) further includes a delivery actuator (14a) that moves the substrate (W) between the spin chuck (10) and the hot plate (14) by relatively moving the spin chuck (10) and the hot plate (14);
the component liquid nozzle (21) discharges the component liquid toward the upper surface of the substrate (W) held by the spin chuck (10) when the spin chuck (10) is rotating the substrate (W);
the hot plate (14) heats the substrate (W) while holding the substrate (W) in a state in which the component liquid is present on the upper surface of the substrate (W) and the gas pressure in the sealed space (SP) is higher than the gas pressure outside the sealed space (SP).

14. The substrate processing apparatus (1) according to claim 13, wherein the relative movement actuator (41a) forms the sealed space (SP) housing the substrate (W) held by the hot plate (14) between the shielding member (41) and the hot plate (14) by sealing the gap between the shielding member (41) and the hot plate (14) in a state in which the component liquid is present on the upper surface of the substrate (W).

15. The substrate processing apparatus (1) according to any one of claims 11 to 14, wherein the shielding member (41) includes:
a tubular portion (41t) that surrounds the substrate (W) held by the substrate holder in a state in which the sealed space (SP) is formed;
a rectifying plate (41r) that is located above the substrate (W) held by the substrate holder;
a plate-shaped portion (41p) that is located above the rectifying plate (41r); and
a gas supply port that supplies the component gas existing in an upper space (SP1), which is a portion of a space inside the tubular portion (41t) and a space between the rectifying plate (41r) and the plate-shaped portion (41p), to a lower space (SP2), which is a portion of the space inside the tubular portion (41t) and a space below the rectifying plate (41r), through a plurality of gas passages (41g) vertically penetrating the rectifying plate (41r) by supplying the component gas to the upper space (SP1).
